**Europäisches Patentamt**

**European Patent Office**

**Office européen des brevets**

(19)

(11) Publication number : **0 195 977 B1**

# EUROPEAN PATENT SPECIFICATION

(12)

(45) Date of publication of patent specification :
28.09.94 Bulletin 94/39

(51) Int. Cl.⁵ : **H01L 21/90, H01L 23/52**

(21) Application number : **86103235.7**

(22) Date of filing : **11.03.86**

(54) **Metal interconnection system with a planar surface.**

(30) Priority : **15.03.85 US 712580**

(43) Date of publication of application :
**01.10.86 Bulletin 86/40**

(45) Publication of the grant of the patent :
**28.09.94 Bulletin 94/39**

(84) Designated Contracting States :
**DE FR GB**

(56) References cited :
**EP-A- 0 046 525
EP-A- 0 156 999
DE-A- 2 032 320
US-A- 4 584 207
INTERNATIONAL ELECTRON DEVICES MEET-
ING 1983, Washington, 5th-7th December
1983, pages 550-553, IEEE, New York, US ; T.
MORIYA et al.: "A planar metallization pro-
cess-its application to tri-level aluminum inter-
connection"**

(56) References cited :
**EXTENDED ABSTRACTS, vol. 84, no. 1, 6th-
11th May 1984, pages 114-115, Pennington,
New York, US ; K.C. SARASWAT et al.:
"Selective CVD of tungsten for VLSI
technology"**

(73) Proprietor : **Hewlett-Packard Company
Mail Stop 20 B-O,
3000 Hanover Street
Palo Alto, California 94304 (US)**

(72) Inventor : **Manley, Robert B.
124 Princeton Road
Ft. Collins Colorado 80525 (US)**
Inventor : **Crook, Mark D.
2918 Adobe Drive
Fort Collins Colorado 80525 (US)**

(74) Representative : **KOHLER SCHMID +
PARTNER
Patentanwälte
Ruppmannstrasse 27
D-70565 Stuttgart (DE)**

## Description

The electrical interconnections between electronic devices are an important part of any functioning circuit. Improper interconnections can reduce the performance of a circuit or prevent the circuit from operating entirely. Traditionally, these interconnections have been made with various conductors including the metals copper and aluminum. In no area are good reliable interconnections more important than in integrated circuits.

The prior art process for interconnecting with a conductor the electronic devices on a silicon wafer is described as follows. Connecting these electronic devices is typically the final step in the construction of the integrated circuit and is also referred to as the metalization process. The process begins with the wafer containing completed electronic devices built into and onto the wafer. These electronic devices including bipolar and field effect transistors are not connected. The surface of the wafer appears smooth, but on the device scale the surface is uneven and contains sharp discontinuities generated as the electronic devices were constructed.

The first step of the prior art process for interconnecting the electronic devices is depositing a dielectric material on the uneven surface of the silicon wafer. Traditionally, the dielectric has been silicon dioxide. The silicon dioxide forms a thin layer on the surface of the wafer. This dielectric layer preserves and can accentuate the discontinuities on the surface of the wafer.

The second step is selectively removing the dielectric material to create holes which expose the contacts of the electronic devices. These holes are formed by selectively etching through the dielectric layer at specific locations. There are several well understood prior art methods for etching through the dielectric layer. These methods typically involve placing a photoresist on the surface of the device, exposing the photoresist to a particular wavelength of light, developing the photoresist to form a mask which exposes the dielectric material where it is to be removed, and removing the exposed dielectric material with either a wet or a dry etchant. Finally, the photoresist mask is removed exposing the dielectric layer.

The third step is depositing a conductor on the surface of the wafer. This conductor is typically aluminum, although other conductors may be used. Two different prior art methods may be used to deposit the conductor. The methods are sputtering, where atoms of the conductor are knocked from a target made of the conductor and splattered onto the surface of the wafer, and evaporation, where the conductor is carried to the wafer in a vapor state and condenses on the surface of the wafer. In addition to providing a uniform layer of conductor on the wafer, this method must also fill the holes created in the previous step. These conductor filled holes are known as vias and serve as contacts to the electronic devices located below the dielectric layer.

The fourth and final step is removing selectively the conductor where it is not needed to form lines. The lines connect the electronic devices to form the desired circuit. This step is performed using a method which is very similar to the selective removal of dielectric and typically involves forming a photoresist mask and removing the conductor with an etchant.

This prior art process of interconnecting the electronic devices is referred to as a "subtractive" process since to form the lines which interconnect the electronic devices, the conductor is first deposited everywhere, then selectively removed. This process may be repeated as necessary to generate additional interconnection layers, although more than two interconnection layers are rare because of the problems described below.

The prior art process has several problems. The first and most severe problem is shorted and open lines.

Open lines occur in the prior art process when the conductor does not cover the sharp discontinuities on the surface of the wafer leaving gaps or opens in the lines. The source of these discontinuities is primarily the basic electronic devices which are built into and onto the wafer and the vias formed in previous process steps. When more than one interconnection layer is used, the problem is further aggravated by the lines in lower levels which themselves create discontinuities in higher layers. The problem is compounded when these discontinuities are accentuated by the typical method used to deposit the dielectric layer on the surface of the wafer. A discontinuity can be modeled by a higher horizontal surface, a first corner, a vertical surface, a second corner, and a lower horizontal surface. The first corner is exposed from the top and side. If this corner is 90 degrees, it has an angle of exposure of 270 degrees. However, the lower corner, if it is 90 degrees, has an angle of exposure of only 90 degrees. A flat surface, for example the higher and lower horizontal and vertical surfaces, are exposed from 180 degrees. Since the typical method of depositing the dielectric has a constant arrival rate, the rate of growth is dependent on the angle of exposure of the surface or corner. Therefore, the first corner, which is exposed more than any other surface, grows the fastest. In fact the first corner grows so fast, faster than the higher horizontal surface, that it begins to rise up above that surface accentuating the discontinuity represented by the original corner.

When the conductor is deposited on the dielectric covered discontinuities, the first corner growth will shadow or mask the vertical surface and the second corner by reducing the angle of exposure. The reduced angle of exposure of the vertical surface and the second corner, reduces the growth rate on those surfaces causing a very thin layer of conductor to be applied or even possibly leaving an open in the conductor. Even assuming

EP 0 195 977 B1

that the vertical wall has no opens after the conductor has been deposited as described above, opens may still develop in the thinly coated walls of the via or in any other thinly coated location. Although the thin spot may test as a complete circuit immediately after construction, the conductor may eventually open due to electromigration. The thinner the conductor is, the higher the flux density for a given current will be through the conductor. The increased flux density in the narrow region may cause electromigration of the conductor atoms resulting in the atoms at the thin spot moving to a thicker spot. This causes the thin spot to become even thinner, eventually resulting in an open. Electromigration is particularly a problem when aluminum is the conductor.

Open and shorted lines also occur in the prior art process when the layer of the conductor is improperly etched. Shorts may be caused by underetching. Underetching occurs when all of the conductor is not removed by the etchant leaving the conductor, for example, between two lines forming a short. Opens and thin spots may be created by overetching, removing too much conductor, or undercutting. Etching occurs where the conductor is exposed through a mask to the etchant, however, what is etched depends on whether the etchant is isotropic or anisotropic. An isotropic etchant etches the conductor at a constant rate in all directions. An anisotropic etchant etches in one direction more rapidly than any other. If the etchant is isotropic in nature, the etchant will begin to dissolve the exposed material, but in all directions. This causes the removal of the conductor directly under the mask and is referred to as undercutting. A certain amount of undercutting is normal. When the conductor is deposited on the surface of the wafer, the conductor will form large overhangs at discontinuities on the wafer for reasons similar to that for the dielectric. When large overhangs are present on the wafer, the conductor must be exposed to the etchant for a longer period of time to prevent shorts. This leads to excessive undercutting which may cause open lines, or thin spots.

If an anisotropic etchant is used, the etchant will begin to dissolve the exposed material but primarily in one direction toward the wafer. Therefore, undercutting is considerably reduced when an anisotropic etchant is used. However, the etchant may leave conductor in the bottom of a discontinuity, thereby causing shorts. This may be understood by referring to the model of a discontinuity above. The etchant must first remove the large overhang of conductor on the first corner and the vertical wall before removing the conductor in the second corner. Because the quantity of conductor which must be removed is considerably more than in any other place on the wafer the etching process may be stopped before the etchant has removed the conductor in the second corner. The conductor remaining in the second corner causes a short between two lines. As geometries approach the one micron level shorts and opens caused by the etching process become an increasing problem.

The second problem with the prior art process is electrically open vias. The vias begin as holes in the dielectric etched in the second step of the prior art process. When the conductor is deposited in the third step, it first covers the top of the dielectric layer and the bottom of the hole. Because the top of the hole has a higher angle of exposure, it begins to build more rapidly, as occurred above with the dielectric at a discontinuity. The excess material at the top of the hole will tend to shadow or mask the vertical walls of the hole, thereby causing the vertical surfaces of the hole to remain uncovered. Absence of the conductor on the side of the via leaves the top and the bottom of the via unconnected causing an open circuit. This problem also becomes more serious as integrated circuit geometries are reduced. One method of depositing the conductor tungsten called chemical vapor deposition has been used to reduce the problem. However, even when the surface surrounding the top and the bottom of the via are properly connected, a dimple is formed at the top of the via. This dimple causes further discontinuities for later interconnect layers.

Finally, a third problem occurs as geometries of the lines are reduced as required for VLSI integrated circuits. The ratio between the height of the line and the width of the line is referred to as the aspect ratio. When the geometries of the lines and vias are reduced, the aspect ratio increases because the lines of the conductor which form the interconnections between the electronic devices are reduced in width, but not in height. As the width of the line becomes narrower, there is less area between the line and the dielectric layer. Therefore there is less area to adhere to the dielectric. The height of the conductor line however is not reduced so the internal forces remain as strong as before. When the internal forces exceed the adhesion force, which occurs more frequently with a high aspect ratio, the line lifts off of the dielectric layer and ruins the integrated circuit.

The prior art means to reducing the problem is to reduce the height of the line. Reducing the height of the line reduces the cross sectional area of the line which increases the resistance of the line. In VLSI circuits where the lines are at the one micron and submicron levels, the line may actually require a very large electronic device to drive the line at a high speed. Since such large devices would operate too slowly, a smaller device and shorter line must be used. This condition is referred to as "wire limited" circuitry and severely restricts circuit design and organization and is therefore undesirable. Also since the prior art process is basically a subtractive process, any overetching during the fourth step of the metalization process will also reduce the width of the lines and cause the same problems with adhesion and "wire limiting" as caused by a reduction in the geometires.

From the conference papers of the "International Electron Devices Meeting 1983, Washington, 5-7 December 1983, pages 550 to 553, there is known a process for forming a multilayer integrated circuit having substantially planarized layers of dielectric and tungsten conductors comprising the steps of:
depositing a first silicon dioxide layer on a substantially non-planarized surface of said integrated circuit to form a first surface; forming a first mask on said first silicon dioxide surface in a first predetermined pattern to expose portions of said first surface to be etched; selectively removing portions of said first silicon dioxide layer corresponding to said first predetermined pattern formed by said first mask using an etchant whereby said etchant activates etched surfaces of said first silicon dioxide layer to initiate the growth of tungsten on said etched surfaces; removing said first mask from said first silicon dioxide surface; growing tungsten on said etched surfaces using chemical vapor deposition techniques; depositing a second silicon dioxide layer on said first surface to form a second surface; forming a second mask on said second surface in a second predetermined pattern to expose portions of said second surface to be etched; selectively removing portions of said second silicon dioxide layer corresponding to said second predetermined pattern formed by said second mask using an etchant whereby said etchant activates etched surfaces of said second silicon dioxide layer to initiate the growth of tungsten on said etched surfaces of said second silicon dioxide layer; and growing tungsten on said etched surfaces of said second silicon dioxide layer using chemical vapor deposition techniques.

In accordance with the present invention as claimed in claim 1, a process is described for electrically interconnecting electronic devices located on a surface through two or more planar linking layers. The same three step process is used for construction of vias and lines for all layers. The process differs from the prior art in that it is an "additive" process which places the conductor only where it is needed, rather than the "substractive" process of the prior art which applies conductor everywhere and then removes the conductor where it is not needed.

The present invention is superior to the prior art in several ways. First, the process is essentially planar, the process does not introduce discontinuities onto the wafer and in fact tends to reduce and eliminate any discontinuities present on the wafer. Second, this process avoids the discontinuities or dimples which occurred at vias in the prior art because the conductor could not be applied in a manner which fills the holes evenly. Finally, this process offers higher adhesion between the line and the surface than was available in the prior art, especially for lines with high aspect ratios.

The use of a planar interconnection scheme avoids many of the prior art problems. A planar interconnection scheme offers a flat and relatively smooth surface on which to build the interconnect lines. This eliminates the shorts and opens caused when the conductor is forced to bend around devices and other lines located on the wafer. Furthermore, since the process is essentially planar, the problems caused in the photoresist masking process by uneven surfaces are avoided. The planar process also offers reduced capacitance because there is more distance between lines and devices in the layered approach than in the prior art process.

The present invention and its preferred embodiments are superior to the prior art process because this process avoids the discontinuities or dimples which are found at vias in the prior art because the conductor fills the hole evenly. Because the conductor is deposited at the bottom of the hole and built up through the hole, this process avoids the opens of the prior art which occurred in the via when the top of the via failed to come into contact with the bottom of the via. Any undercutting which might have occurred during the etching process used to remove the dielectric is an advantage for integrated circuits constructed in accordance with the present invention. If the dielectric is undercut, more conductor is used to fill the via or line. This results in a larger line with a lower resistance which means a longer line may be used before the circuitry becomes "wire limited".

Finally, when the conductor is desposited in the trench to form a line, there is more contact area between with the conductor and the dielectric and therefore better adhesion than when the line is deposited on top of the wafer. All of these reasons make the present invention and its preferred embodiments a substantial improvement over the prior art.

Fig. 1       is a side view of a typical silicon wafer with electronic devices on its surface.

Fig. 2       is a side view of the wafer of Fig. 1 illustrating the first dielectric layer which results from the first step of a process in accordance with the present invention.

Fig. 3       is a side view of the wafer illustrating holes in the dielectric layer which result from the second step of the process.

Fig. 4       is a side view of the wafer illustrating the vias of the dielectric layer which result from the third step in the process.

Fig. 5       is a side view of the wafer illustrating a second dielectric layer which results from repeating the first step of the process.

Fig. 6       is a side view of the wafer illustrating holes and trenches in the second dielectric layer which result from repeating the second step of the process.

Fig. 7       is a side view of the wafer illustrating the vias and lines in the second dielectric layer which result from repeating the third step of the process.

Fig. 8    is a side view of the wafer illustrating a third dielectric layer which results from repeating the first step of the process.

Fig. 9    is a side view of the wafer illustrating holes and trenches in the third dielectric layer which result from repeating the second step of the process.

Fig. 10    is a side view of the wafer illustrating the vias and lines in the third dielectric layer which result from repeating the third step of the process.

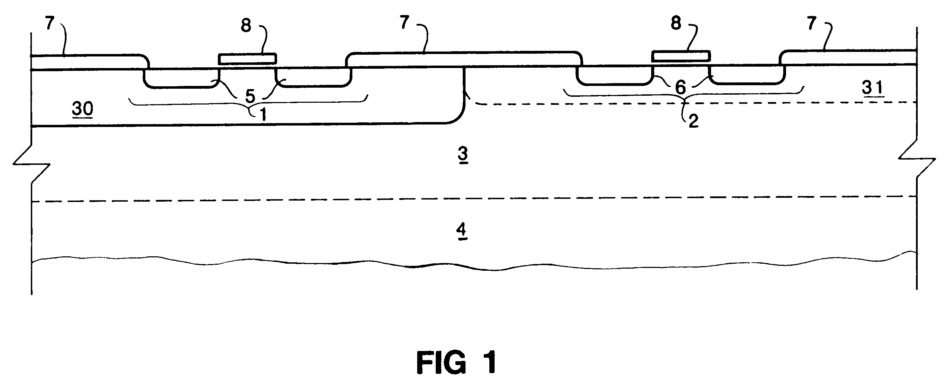

A process in accordance with the present invention begins with a silicon wafer which has the electronic devices built into and onto the surface of the wafer and which is ready to have the interconnections between electronic devices added to the wafer. Fig. 1 is a side view of a typical silicon wafer 4 with epitaxy layer 3 grown onto the silicon wafer 4. A p-tub 30 and an n-tub 31 are diffused into the epitaxy layer 3. Electonic devices 1 and 2 are built into the n-tub and p-tub respectively. The wafer is now ready to have the interconnections between devices added to make a functional circuit.

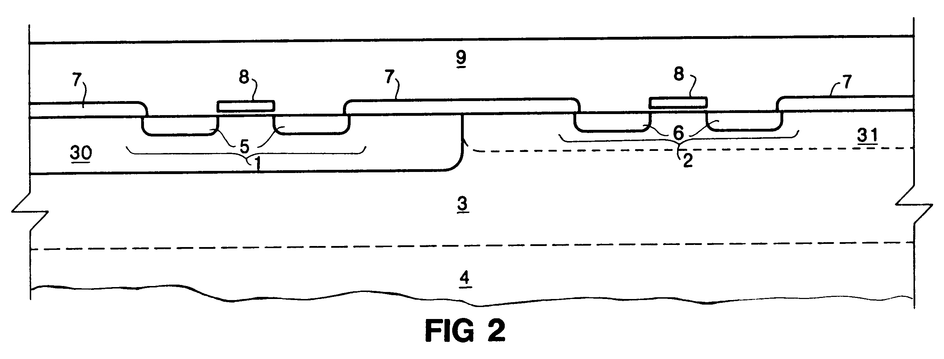

The first step of the process is to deposit a first polyimide layer on the surface of the wafer. In the preferred embodiment of the present invention, the layer of polyimide deposited on the surface of the wafer is followed by a layer of silicon dioxide (oxide). Polyimide is a spin-on polymer dielectric having addition surface tension characteristics which tend to planarize the surface of the wafer making it smooth even at the device level. The oxide layer is placed on top of the polyimide layer for reasons explained below. Fig. 2 is a side view of the wafer of Fig. 1 illustrating the first dielectric layer 9 which results from the first step of the process. This first dielectric layer serves as an insulator between the electronic devices 1 and 2 and the lines in any subsequent linking layers.

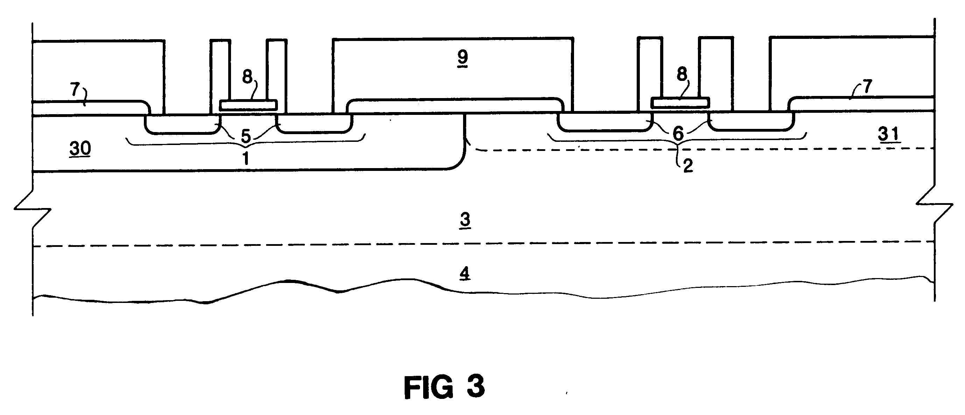

The second step of the process is to selectively remove portions of the dielectric layer to expose the contacts of the electronic devices. Various prior art techniques may be used to remove the dielectric and create holes through which the electronic devices may be connected. In the preferred embodiment of the present invention, a photoresist is applied to the surface of the first dielectric layer. The photoresist is exposed with a particular wavelength of light where the contacts of the electronic device are located. The photoresist is then developed to form a mask which exposes the dielectric at these locations. The dielectric is then removed with a dry etchant. A wet etchant would also be used to remove the dielectric. Both wet and dry etchants are well known in the prior art. The mask is then removed. Fig. 3 is a side view of the wafer illustrating the holes in the first dielectric layer 9 which result from the second step of the process.

The third step of the process is to selectively deposit a conductor in the holes created in the first dielectric layer 9. The conductor is not deposited on top of the dielectric. In the present invention, a method for selectively depositing the conductor tungsten on the wafer is used. This method employs a technique known as chemical vapor deposition of tungsten or CVD Tungsten. CVD Tungsten deposition operates as follows. The surface of the wafer onto which the conductor is to be deposited is exposed to a gas consisting of $WF_6$ and diatomic hydrogen. No reaction occurs until the gas is exposed to a catalyst. A catalyst, for example, a metal or a silicide on the surface of the wafer causes the diatomic hydrogen to disassociate into two monatomic hydrogen atoms. The monatomic hydrogen atom then reacts with $WF_n$ as follows:

$$WF_n + H \rightarrow HF + WF_{n-1}$$

The above reaction is repeated until a tungsten atom is deposited on the surface of the catalyst. Since tungsten, a metal, acts as a catalyst itself the reaction continues until the wafer is removed from the gas. Silicon will also act as a catalyst. The use of this technique is known in the prior art and is further described in the following articles: Thick Tungsten Films in Multilayer Conduction Systems: Properties and Deposition Techniques, R.S. Blewer and V.A. Wells. Proceedings of the First IEEE VLSI Multilayer Interconnection Conference, June-21-22, 1984, Page 153; and Selective Low Pressure Chemical Vapor Deposition of Tungsten, E.K. Broadbent, C.L. Ramiller, Journal of Electrochemical Society, Vol. 131, No. 6, Page 1427, June 1984.

In order for the tungsten to be selectively deposited, an area may need to be activated or deactivated. Activation is required when the material which makes up the bottom and sides of the hole or trench will not start the growth of the conductor. Deactivation is required when the material on the surface of the wafer will start the growth of the conductor where it is not desired. For tungsten: any metal, silicon, or silicide will act as an activator to start the growth of tungsten and any oxide or silicon nitride will act as a deactivator to prevent the growth of tungsten. Polyimide in an undamaged state will act as a deactivator. However, if the atomic structure of the polyimide has been damaged, for example, by exposure to an etchant in a previous process step, polyimide will act as an activator to start the growth of tungsten.

Activation and deactivation may occur without a separate step. For example, tungsten will be deposited selectively in holes and trenches but not on the surface of the dielectric where the bottom of a hole or trench exposes etched polyimide or metal and the surface of the dielectric is undamaged polyimide. In these cases, conductor will be selectively deposited without further action. In the present invention, polyimide is used as the dielectric. Where the dielectric is polyimide, the damaged polyimide which lines the sides of the etched hole acts as a catalyst to cause tungsten to be deposited. However, the surface of the polyimide constructed may be damaged and therefore require deactivation. In the preferred embodiment, this is accomplished by applying a layer of oxide on top of the polyimide as described above in the first step of the process which deposits the dielectric layer. Where a silicon dioxide is used as a deactivator, the bottom of trenches which are not metal will require activation.

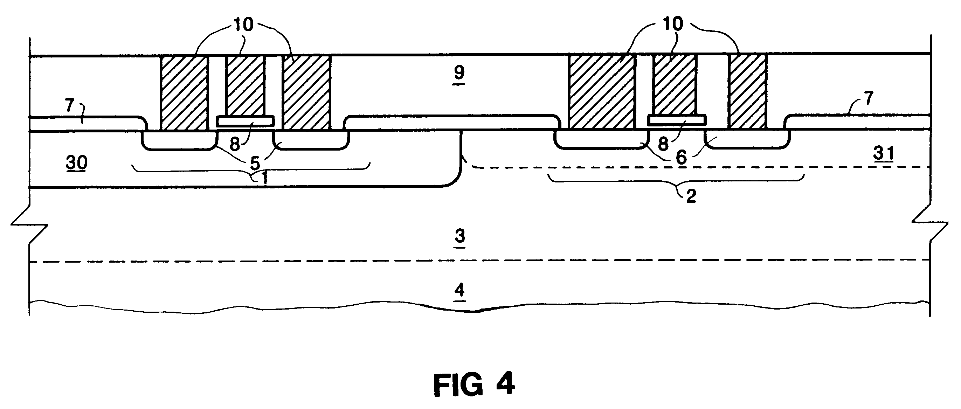

Fig. 4 is a side view of the wafer illustrating the conductor filled holes, or vias, 10 in the first dielectric layer 9 which result from the third step of the process. The metal at the bottom of the hole and the damaged polyimide on the sides of the hole act as a catalyst to start the growth of the conductor. Once the tungsten has covered the base of the hole, tungsten begins to grow up through the hole, and eventually becomes approximately level with the top of the hole. This completes the first linking layer. The first linking layer primarily acts to isolate the electronic devices 1 and 2 from later linking layers and to provide contacts to the elctronic devices for later linking layers.

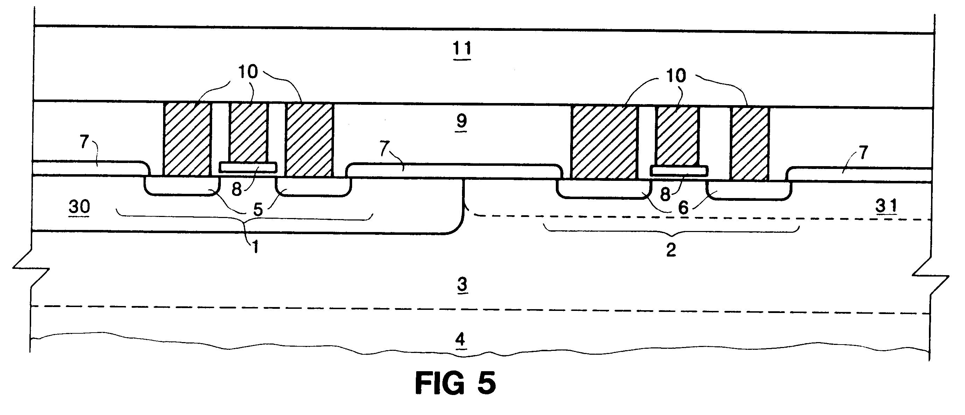

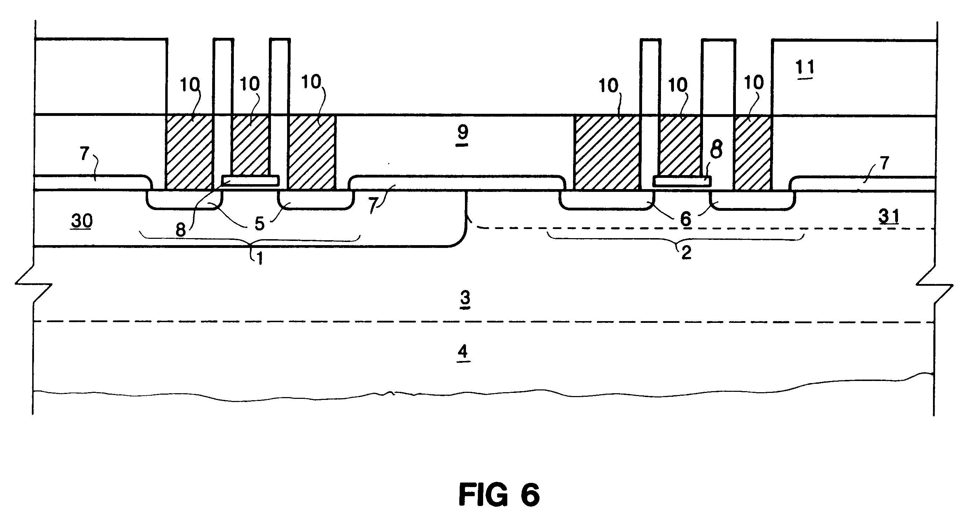

The fourth step of the process is to repeat the first three steps of the process. The second linking layer primarily acts to interconnect the electronic devices by connecting the vias in the first planar layer with lines in the second planar layer. The second linking layer may also contain vias for later linking layers. The fourth step is illustrated by Fig. 5, 6, and 7. First, a second dielectric layer is deposited on top of the first dielectric layer using the method described above in the first step. Fig. 5 is a side view of the wafer illustrating a second dielectric layer 11 which results from repeating the first step of the process. If a deactivation layer has been used in the previous steps, it may be removed before applying the second dielectric layer, or it may be left and removed where it is not required during the selective removal of the second dielectric layer. In the preferred embodiment, the layer is not removed before another dielectric layer is deposited, rather the oxide deactivation layer is removed only when necessary as part of the following step. Second, the second dielectric layer is selectively removed to create holes for vias and trenches for lines. The holes and trenches may be created by any method such as the one described above in the second step. Fig. 6 is a side view of the wafer illustrating the holes and trenches in the second dielectric layer 11 which result from repeating the second step of the process.

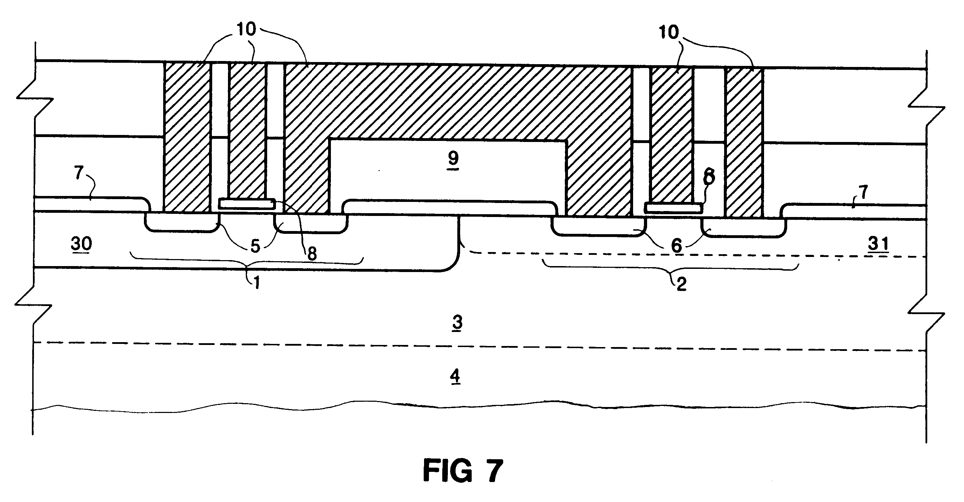

Finally, the holes and trenches created in the second step are filled with a conductor using any process such as the one described above in the third step, to form vias and lines respectively. Fig. 7 is a side view of the wafer illustrating the vias and lines in the second dielectric layer which result from repeating the third step of the process. The vias and lines 10 reach through the entire second dielectric layer 11 to make a good electrical connection with the vias in the first dielectric 9.

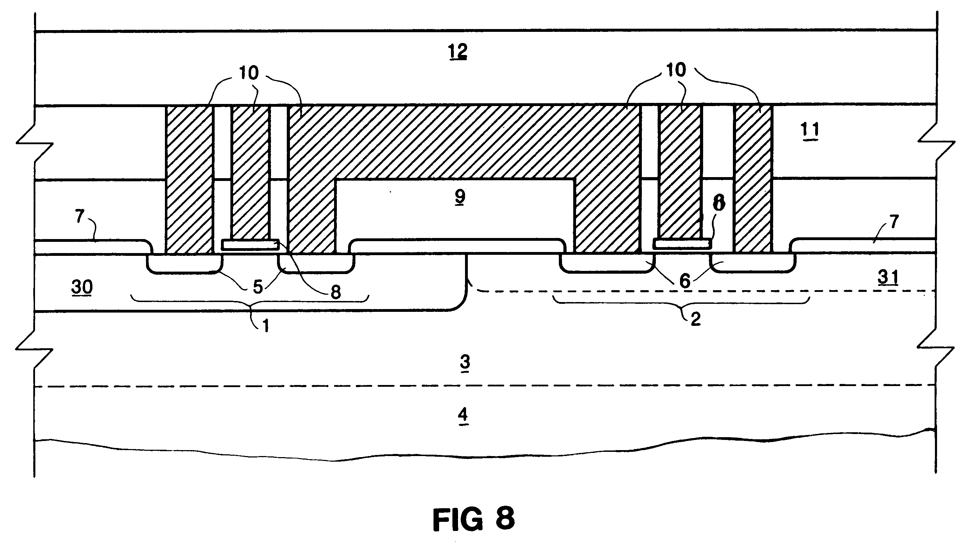

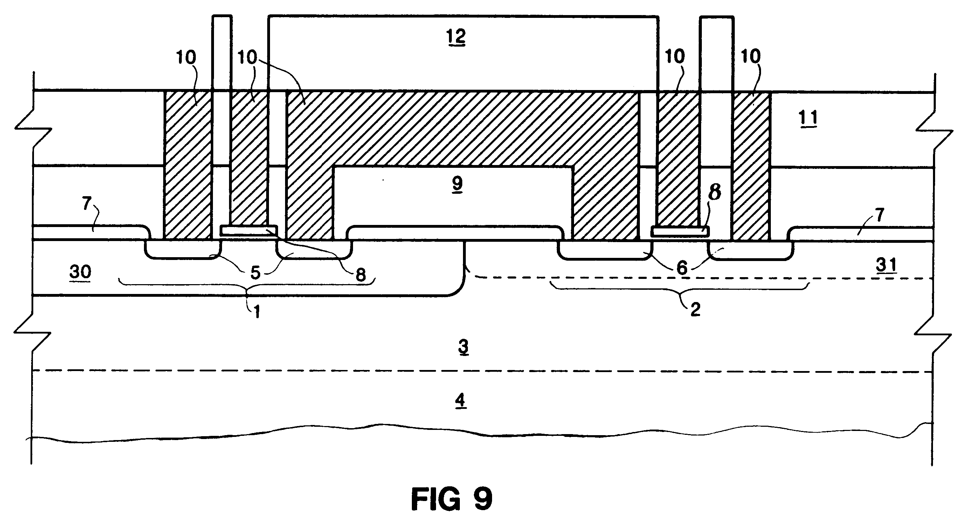

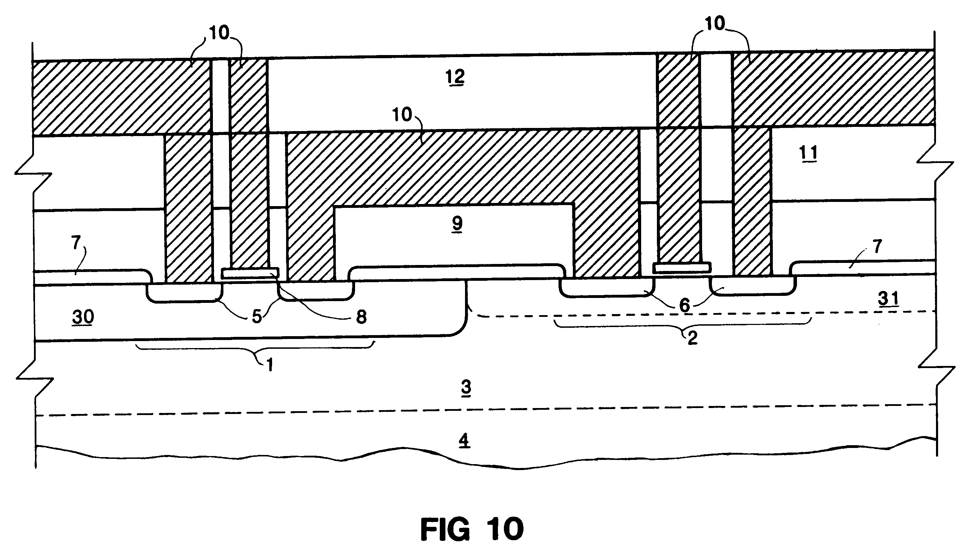

A third linking layer may then be added to interconnect the vias created above in the fourth step. This third planar linking layer, like the second planar linking layer, may be produced by repeating the fourth step of the process. In fact, the fourth step may be repeated as many times as necessary to completely interconnect the electronic devices located on the wafer. Since each layer is planar there are none of the problems of the prior art discussed above. Fig. 8, 9, and 10 illustrate a third linking layer. The same three steps are repeated. First, a third dielectric layer is deposited on top of the second dielectric layer using any method such as the method described above in the first step. Fig. 8 is a side view of the wafer illustrating a third dielectric layer 12 which results from repeating the first step of the process. Second, the third layer of the dielectric is selectively removed to create holes and trenches in the third layer. The holes and trenches are selectively created in the dielectric where the vias and interconnections are to be made. The holes and trenches may be created by any method such as the one described above in the second step. Fig. 7 is a side view of the wafer illustrating the holes and trenches in the third dielectric layer 12 which result from repeating the second step of the process. Finally, the holes and trenches created in the second step are filled with a conductor using any process such as the one described above in the third step. Fig. 7 is a side view of the wafer illustrating the vias and lines 10 in the third dielectric layer 12 which result from repeating the third step of the process. Each via and line 10 reaches through the entire third linking layer to make a good electrical connection with the vias and lines in the second linking layer.

The present invention may be used to make interconnections on any relatively smooth surface.

## Claims

1. A process for forming a multilayer integrated circuit having substantially planarized layers of dielectric and tungsten conductors comprising the steps of: depositing a first polyimide layer on a substantially non-planarized surface of said integrated circuit to form a first substantially planarized surface; forming a first mask over said first polyimide surface in a first predetermined pattern to expose portions of said first substantially planarized surface to be etched; selectively removing portions of said first polyimide layer corresponding to said first predetermined pattern formed by said first mask using an etchant whereby said etchant activates etched surfaces of said first polyimide layer by damaging said etched surfaces of said first polyimide layer to initiate the growth of tungsten on said etched surfaces; removing said first mask from said first polyimide surface; growing tungsten on said etched surfaces using chemical vapor deposition techniques until said tungsten substantially fills said selectively removed portions of said first polyimide layer and the surface of the deposited tungsten becomes approximately level with said first substantially planarized surface of said first polyimide layer; depositing a second polyimide layer on said first substantially planarized surface consisting of said first polyimide layer and of deposited tungsten to form a second substantially planarized surface; forming a second mask over said second substantially planarized surface in a second predetermined pattern to expose portions of said second substantially planarized surface to be etched; selectively removing portions of said second polyimide layer corresponding to said second predetermined pattern formed by said second mask to form vias and trenches for interconnecting lines to be formed, exposing thus portions of the first substantially planarized surface using an etchant whereby said etchant activates etched surfaces of said first and second polyimide layer by damaging said etched surfaces of said first and second polyimide layer to initiate the growth of tungsten on said etched surfaces of said first and second polyimide layer; removing said second mask from said second polyimide layer; and growing tungsten on etched surfaces of said first and second polyimide layer using chemical vapor deposition techniques until said tungsten substantially fills said selectively removed portions of said second polyimide layer and the surface of the deposited tungsten becomes approximately level with said second substantially planarized surface of said second polyimide layer.

2. The process of claim 1 further comprising the steps of: depositing additional polyimide layers; forming additional masks on said additional polyimide layers; selectively removing portions of said additional polyimide layers with an etchant and activating thus etched surfaces of said second and/or said additional polyimide layers respectively; growing tungsten on said etched surfaces by using chemical vapor deposition techniques until the surface of the deposited tungsten is substantially identical with the surface of the respective additional polyimide layer.

3. The process according to claim 1 or 2, characterized in that said steps of depositing said first, second and additional polyimide layers are respectively directly followed by a step of depositing a layer of silicon dioxide on the surface of said respective first, second or additional polyimide layers, said layer of silicon dioxide acting as a deactivator for tungsten growth in said respective subsequent step of the chemical vapor deposition of tungsten.

**Patentansprüche**

1. Verfahren zum Bilden einer integrierten Schaltung mit mehreren Schichten mit im wesentlichen planarisierten Schichten aus dielektrischen und Wolfram-Leitern mit den folgenden Schritten:
Aufbringen einer ersten Polyimid-Schicht auf eine im wesentlichen nicht-planarisierte Oberfläche der integrierten Schaltung, um eine erste im wesentlichen planarisierte Oberfläche zu bilden;
Bilden einer ersten Maske über der ersten Polyimid-Oberfläche in einem ersten vorbestimmten Muster, um Abschnitte der ersten im wesentlichen planarisierten Oberfläche zum Ätzen freizulegen;
selektives Entfernen von Abschnitten der ersten Polyimid-Schicht gemäß dem ersten von der ersten Maske gebildeten vorbestimmten Muster unter Verwendung eines Ätzmittels, wobei das Ätzmittel geätze Oberflächen der ersten Polyimid-Schicht aktiviert, indem die geätzen Oberflächen der ersten Polyimid-Schicht beschädigt werden, um das Wachstum von Wolfram auf den geätzten Oberflächen auszulösen;
Entfernen der ersten Maske von der ersten Polyimid-Oberfläche;
Wachstum von Wolfram auf den geätzten Oberflächen unter Verwendung von Aufdampf-(CVD)-Techniken, bis das Wolfram im wesentlichen die selektiv beseitigten Abschnitte der ersten Polyimid-Schicht füllt und die Oberfläche des abgelagerten Wolfram ungefähr mit der ersten im wesentlichen planarisierten Oberfläche der ersten Polyimid-Schicht bündig wird;
Aufbringen einer zweiten Polyimid-Schicht auf der ersten im wesentlichen planarisierten Oberfläche, die aus der ersten Polyimid-Schicht und aus aufgebrachtem Wolfram besteht, um eine zweite im wesentlichen planarisierte Oberfläche zu bilden;
Bilden einer zweiten Maske über der zweiten im wesentlichen planarisierten Oberfläche in einem zweiten vorbestimmten Muster, um Abschnitte der zweiten im wesentlichen planarisierten Oberfläche zum Ätzen freizulegen; selektives Entfernen von Abschnitten der zweiten Polyimid-Schicht entsprechend dem zweiten vorbestimmten Muster, das von der zweiten Maske gebildet wird, um Wege und Gräben für Verbindungslinien zu gestalten, die gebildet werden sollen, wobei Abschnitte der ersten im wesentlichen planarisierten Oberfläche einem Ätzmittel ausgesetzt werden, wodurch das Ätzmittel geätze Oberflächen der ersten und zweiten Polyimid-Schicht aktiviert, indem die geätzten Oberflächen der ersten und zweiten Polyimid-Schicht beschädigt werden, um das Wachstum von Wolfram auf den geätzten Oberflächen der ersten und zweiten Polyimid-Schicht auszulösen; Entfernen der zweiten Maske von der zweiten Polyimid-Schicht; und

Wachstum von Wolfram auf geätzten Oberflächen der ersten und zweiten Polyimid-Schicht unter Verwendung von Aufdampf-(CVD)-Techniken, bis das Wolfram im wesentlichen die selektiv beseitigten Abschnitte der zweiten Polyimid-Schicht füllt und die Oberfläche des aufgebrachten Wolfram ungefähr mit der zweiten im wesentlichen planarisierten Oberfläche der zweiten Polyimid-Schicht bündig wird.

2. Verfahren nach Anspruch 1, das weiterhin die folgenden Schritte aufweist:
Aufbringen von zusätzlichen Polyimid-Schichten;
Bilden von zusätzlichen Masken auf den zusätzlichen Polyimid-Schichten;
selektives Entfernen von Abschnitten der zusätzlichen Polyimid-Schichten mit einem Ätzmittel und Aktivierung von dergestalt geätzten Oberflächen der zweiten bzw. und/oder den zusätzlichen Polyimid-Schichten;
Wachstum von Wolfram auf den geätzten Oberflächen durch Verwendung von Aufdampf-(CVD)-Techniken, bis die Oberfläche des aufgebrachten Wolfram im wesentlichen mit der Oberfläche der jeweiligen zusätzlichen Polyimid-Schicht identisch ist.

3. Verfahren nach Anspruch 1 oder 2, dadurch gekennzeichnet, daß auf die Schritte des Aufbringens der ersten, zweiten und zusätzlichen Polyimid-Schichten jeweils direkt ein Schritt folgt, bei dem eine Schicht aus Silicium-Dioxid auf die Oberfläche der jeweiligen ersten, zweiten oder zusätzlichen Polyimid-Schichten aufgebracht wird, wobei die Schicht aus Silicium-Dioxid als Deaktivator für ein Wachstum von Wolfram in dem jeweiligen nachfolgenden Schritt der CVD-Aufdampfung von Wolfram wirkt.

## Revendications

1. Procédé de formation d'un circuit intégré multicouches ayant des couches sensiblement aplanies de diélectrique et de conducteurs au tungstène comportant les étapes de: dépôt d'une première couche de polyimide sur une surface sensiblement non-aplanie dudit circuit intégré afin de constituer une première surface sensiblement aplanie; constitution d'un premier masque sur ladite première surface de polyimide selon un premier motif prédéterminé, pour exposer à la gravure des parties de ladite première surface sensiblement aplanie; élimination sélective des parties de ladite première couche de polyimide correspondant audit premier motif prédéterminé constitué par ledit premier masque, en utilisant un produit de gravure, ce par quoi ledit produit de gravure active les surfaces gravées de ladite première couche de polyimide, en attaquant lesdites surfaces gravées de ladite première couche de polyimide pour initialiser la croissance de tungstène sur lesdites surfaces gravées; élimination dudit premier masque de ladite première surface de polyimide; croissance de tungstène sur lesdites surfaces gravées en utilisant des techniques de dépôt sous vapeur chimique, jusqu'à ce que ledit tungstène remplisse sensiblement lesdites parties éliminées de façon sélective de ladite première couche de polyimide et que la surface du tungstène déposé atteigne approximativement le même niveau que ladite première surface sensiblement aplanie de ladite première couche de polyimide; dépôt d'une seconde couche de polyimide sur ladite première surface sensiblement aplanie constituée de ladite première couche de polyimide et du tungstène déposé, afin de constituer une seconde surface sensiblement aplanie; constitution d'un second masque sur ladite seconde surface sensiblement aplanie selon un second motif prédéterminé, pour exposer à la gravure des parties de ladite seconde surface sensiblement aplanie; élimination sélective des parties de ladite seconde couche de polyimide correspondant audit second motif prédéterminé constitué par ledit second masque, pour constituer des passages et des tranchées destinés à interconnecter les lignes devant être constituées, en exposant ainsi les parties de ladite première surface sensiblement aplanie en utilisant un produit de gravure, ce par quoi ledit produit de gravure active les surfaces gravées de ladite première et de ladite seconde couche de polyimide en attaquant lesdites surfaces gravées de ladite première et de ladite seconde couche de polyimide pour initialiser la croissance de tungstène sur lesdites surfaces gravées de ladite première et de ladite seconde couche de polyimide; élimination dudit second masque de ladite seconde couche de polyimide; et croissance de tungstène sur les surfaces gravées de ladite première et de ladite seconde couche de polyimide, en utilisant des techniques de dépôt sous vapeur chimique, jusqu'à ce que ledit tungstène remplisse sensiblement lesdites parties éliminées de façon sélective de ladite seconde couche de polyimide, et que la surface du tungstène déposé atteigne approximativement le même niveau que ladite seconde surface sensiblement aplanie de ladite seconde couche de polyimide.

2. Procédé selon la revendication 1, comportant en outre les étapes de dépôt de couches de polyimide supplémentaires; constitution de masques supplémentaires sur lesdites couches de polyimide supplémentaires; élimination sélective de parties desdites couches de polyimide supplémentaires avec un produit de gravure et activation respective des surfaces ainsi gravées de ladite seconde et/ou desdites couches de polyimide supplémentaires; croissance de tungstène sur lesdites surfaces gravées en utilisant des techniques de dépôt sous vapeur chimique, jusqu'à ce que la surface du tungstène déposé soit sensiblement identique à la surface des couches de polyimide supplémentaires respectives.

3. Procédé selon la revendication 1 ou 2, caractérisé en ce que lesdites étapes de dépôt desdites première et seconde couches de polyimide et desdites couches de polyimide supplémentaires sont respectivement directement suivies par une étape de dépôt d'une couche de dioxyde de silicium sur la surface respectivement desdites première ou seconde couches de polyimide ou desdites couches de polyimide supplémentaires, ladite couche de dioxyde de silicium agissant comme un désactivateur pour la croissance de tungstène dans ladite étape suivante respective de dépôt de tungstène sous vapeur chimique.

**FIG 1**

EP 0 195 977 B1

**FIG 2**

EP 0 195 977 B1

FIG 3

FIG 4

**FIG 5**

EP 0 195 977 B1

**FIG 6**

EP 0 195 977 B1

**FIG 7**

EP 0 195 977 B1

**FIG 8**

EP 0 195 977 B1

FIG 9

**FIG 10**

EP 0 195 977 B1